(19) Europäisches Patentamt
European Patent Office
Office européen des brevets

(11) **EP 2 887 087 A1**

(12) **EUROPEAN PATENT APPLICATION**

(43) Date of publication:
24.06.2015 Bulletin 2015/26

(51) Int Cl.:
*G01R 33/36* (2006.01)   *G01R 33/565* (2006.01)

(21) Application number: 13197707.6

(22) Date of filing: 17.12.2013

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Koninklijke Philips N.V.**
 **5656 AE Eindhoven (NL)**
• **Philips Deutschland GmbH**
 **20099 Hamburg (DE)**
 Designated Contracting States:
 **DE**

(72) Inventor: **The designation of the inventor has not yet been filed**

(74) Representative: **Cohen, Julius Simon et al**
**Philips**
**Intellectual Property & Standards**
**P.O. Box 220**
**5600 AE Eindhoven (NL)**

(54) **Flexible radio frequency channel-to-radio frequency antenna configuration based on region of interest or portion of anatomy**

(57) A radio frequency channel-to-radio frequency antenna configurator (38) for providing radio frequency connections between radio frequency channels (40) and radio frequency antennae (62, 64, 66), for use in a magnetic resonance imaging system (10) is disclosed having a radio frequency splitter/combiner and switch unit (46) that is provided for semi-automatically establishing a preset and user-defined coupling pattern formed by $n_{sel}$ radio frequency antennae out of a plurality of n radio frequency antennae (62, 64) being radio frequency-connected to $m_{sel}$ radio frequency channels of a plurality of m radio frequency channels (40), wherein the number $m_{sel}$ is less than the number $n_{sel}$, and wherein the preset and user-defined coupling pattern is semi-automatically established in dependence of a portion of the anatomy of the subject of interest (20) to be imaged or the region of interest within the portion of the subject of interest (20) to be imaged; and

a magnetic resonance imaging system (10) configured for acquiring magnetic resonance signals from at least a portion of a subject of interest (20), comprising an examination space (16), a main magnet (14) for generating a substantially static magnetic field in the examination space (16), a magnetic gradient coil system (22) for generating gradient magnetic fields superimposed to the static magnetic field; and at least one embodiment of the disclosed radio frequency channel-to-radio frequency antenna configurators (38) or a combination thereof.

FIG. 2

**Description**

FIELD OF THE INVENTION

The invention pertains to the field of magnetic resonance imaging, and more specifically to magnetic resonance imaging systems employing multi-channel radio frequency transmission.

BACKGROUND OF THE INVENTION

In the art of magnetic resonance imaging, it is known to employ independent radio frequency channels in parallel to improve homogeneity of a transmitted radio frequency field $B_1$ for the purpose of magnetic resonance excitation of nuclei within a subject of interest, and for reducing a specific absorption rate especially in high-field (magnetic field strength equal to or more than 3 T) applications. The known technique allows for an appropriate shaping of transmitted radio frequency field $B_1$ to meet best wave propagation properties of a region of the subject of interest under investigation.

Capabilities for radio frequency shimming of a radio frequency transmit system, in particular for high-field applications, increase with a number of independent transmit members that are able to transmit simultaneously. However, there are limitations for this number due to radio frequency amplifier costs, space constraints for cabling, calibration, and others.

SUMMARY OF THE INVENTION

The invention is based on the insight that different portions of the anatomy or regions of interest within the portion of a subject of interest to be imaged distort an applied radio frequency excitation field $B_1$ in different ways, as do same portions of the anatomy or same regions of interest within the same portion of different subjects of interest. Thus, different radio frequency amplitude settings become necessary for an employed radio frequency transmit device having multiple independent radio frequency channels in order to obtain optimum radio frequency shimming results.

It is therefore desirable to provide an improved multiple independent radio frequency channel device for radio frequency shimming that is operative in a highly flexible way, that is cost-effective, and that is able to account for the field distortions of an applied radio frequency excitation field $B_1$ caused by the different portions of a subject of interest to be imaged.

It is therefore an object of the invention to provide a radio frequency channel-to-radio frequency antenna configurator for providing radio frequency connections between radio frequency channels and radio frequency antennae, for use in a magnetic resonance imaging system configured for acquiring magnetic resonance signals from at least a portion of a subject of interest, comprising:

- a plurality of m independent radio frequency channels, each radio frequency channel including at least a radio frequency input member and a radio frequency amplifier;
- a plurality of n radio frequency antennae, wherein each radio frequency antenna is provided at least for transmitting a radio frequency field to excite nuclei within the portion of the subject of interest for the purpose of magnetic resonance excitation,
  wherein the number m is less than the number n;
- a radio frequency splitter/combiner and switch unit that is provided for semi-automatically establishing a pre-set and user-defined coupling pattern formed by $n_{sel}$ radio frequency antennae out of the plurality of n radio frequency antennae being radio frequency-connected to $m_{sel}$ radio frequency channels of the plurality of m radio frequency channels, wherein the number $m_{sel}$ is less than the number $n_{sel}$, and wherein the pre-set and user-defined coupling pattern is semi-automatically established in dependence of a portion of the anatomy of the subject of interest to be imaged or the region of interest within the portion of the subject of interest to be imaged.

The phrase "radio frequency connections", as used in this application, shall be understood particularly as a connection provided to enable the transfer of radio frequency power between two objects connected by a radio frequency connection. The phrase shall encompass galvanic connections between the two objects as well as connections by resistances and/or reactances. Mutual coupling between radio frequency antennae due to coupled magnetic flux shall explicitly not be encompassed by this phrase.

The phrase "semi-automatically", as used in this application, shall be understood particularly as used for a process that is automatically executed in parts but requires human intervention, such as a selecting action, a confirming action or an activating action.

The phrase "portion of the anatomy", as used in this application, shall be understood particularly, but not limited to, as an anatomical entity of the subject of interest such as an organ, an extremity, the head, a muscle, a gland, a blood vessel, or a bone.

The phrase "region of interest", as used in this application, shall be understood particularly as a region of the subject of interest that may completely or partially include several portions of the anatomy of the subject of interest.

One advantage lies in that the radio frequency channel-to-radio frequency antenna configurator can provide improved options for generating a homogeneous radio frequency field in the presence of the subject of interest by radio frequency shimming in a situation in which less independent radio frequency sources than radio frequency antennae are available, which results in cost savings and relaxed requirements regarding allocated space.

As another advantage the available plurality of independent radio frequency channels can be radio frequency-connected to different types of radio frequency antennae, such as a multi-purpose whole-body coil array or a local coil array dedicated for certain body regions.

The invention makes use of the insight that different portions of the subject of interest require different radio frequency shimming for establishing a homogeneous radio frequency field. This applies to the widely-used type of magnetic resonance imaging systems with a magnetic field strength of less than 3 Tesla already, but is more pronounced in high magnetic field applications, i.e. for a maximum static magnetic field strength of the magnetic resonance imaging system of equal to or more than 3 Tesla.

Therefore, another advantage lies in that pre-set and user-defined coupling patterns with a close-to-the-optimum radio frequency shimming in the presence of the subject of interest can be quickly established once a portion of the anatomy of the subject of interest to be imaged or a selected region of interest within the portion of the subject of interest to be imaged has been selected.

The preset and user-defined coupling patterns may have been determined in a calibration measurement as a preparatory step prior to the magnetic resonance imaging of at least the portion of the subject of interest. The coupling patterns may also be predefined by an involved hardware, for instance by the employed radio frequency splitter/combiner.

In some cases, and independent of a magnetic field strength of the magnetic resonance imaging system, a desired optimum radio frequency shimming result may be one with an inhomogeneous radio frequency magnetic excitation field $B_1$, with a flat characteristic proximal to the portion of the subject of interest to be imaged but approaching zero close to implants of the subject of interest, for instance pacemakers, for reducing a risk of heating or electromagnetic interference.

In a preferred embodiment, at least one radio frequency antenna of the plurality of n radio frequency antennae is configured as a local coil. The phrase "local coil", as used in this application, shall be understood particularly as a coil that is configured for being positioned proximal to the portion of the subject of interest to be imaged during magnetic resonance imaging, and that is in particular removable from an examination space of a magnetic resonance imaging system. Usually, local coils are positioned close to a surface of the subject of interest, and are therefore also called surface coils.

An advantage of this embodiment is that local coils can provide options of local optimum radio frequency shimming in the vicinity of the portion of the subject of interest to be imaged.

In another preferred embodiment, at least one radio frequency antenna of the plurality of n radio frequency antennae is configured as a body coil. The phrase "body coil", as used in this application, shall be understood particularly as a coil that provides a space intended to position at least a portion of the subject of interest within, such that at least the portion of the subject of interest is substantially encompassed by the body coil. By that, a radio frequency field can be transmitted having an excellent homogeneity at the intended location of the portion of the subject of interest to be imaged, in the absence of the subject of interest, which can serve as a basic radio frequency field to start radio frequency shimming from once the subject of interest is positioned at least partially in the body coil.

In yet another embodiment, at least one radio frequency antenna of the plurality of n radio frequency antennae is configured for transmitting radio frequency energy for excitation of nuclei during a first time period and for receiving magnetic resonance signals from the excited nuclei during a second time period which is distinct from the first time period. By that, a homogeneous radio frequency field for excitation of nuclei and a high signal-to-noise ratio for acquired magnetic resonance signals from at least the portion of the subject of interest can be accomplished in combination.

Preferably, a transition time from a first pre-set and user-defined coupling pattern to a second pre-set and user-defined coupling pattern that is distinct from the first preset and user-defined coupling pattern in a majority of connections of the first pre-set and user-defined coupling pattern, is less than a millisecond. It shall be understood that a transition time from the first pre-set and user-defined coupling pattern to the second pre-set and user-defined coupling pattern, wherein the second pre-set and user-defined coupling pattern is distinct from the first pre-set and user-defined coupling pattern in fewer connections than a majority of connections of the first pre-set and user-defined coupling pattern, is usually even shorter than that. By that, further options for fast magnetic resonance imaging methods can be enabled, for instance for sub-milliseconds imaging or ultra-short echo imaging. In particular, in a suitable embodiment, a body coil can be switched from a resonant transmitting mode to a resonant receiving mode, and a local coil that is in a receiving mode can be tuned to the magnetic resonance frequency while the body coil is in the resonant receiving mode.

The radio frequency splitter/combiner and switch unit may comprise at least one Butler matrix. Thereby, a pre-set and user-defined coupling pattern formed by $n_{sel}$ radio frequency antennae out of the plurality of n radio frequency antennae being radio frequency-connected to $m_{sel}$ radio frequency channels, wherein $m_{sel}$ is less than $n_{sel}$, can be realized in an easy and cost-saving way.

A Butler matrix is a scalable power splitter, which distributes radio frequency power fed to a certain input port equally to a number of output ports. A phase distribution at the output ports depends on which input port has been chosen. Being a linear device, the Butler matrix superimposes inputs (the weighted sum of 45° or 90 ° between neighboring channels). An optimizing algorithm may be applied to calculate an optimum combination in the case of using less than the maximum available number of inputs of the Butler matrix.

In another aspect of the invention, a method of operating a magnetic resonance imaging system is provided, wherein the magnetic resonance imaging system includes an examination space provided to position a subject of interest within, a main magnet for generating a substantially static magnetic field in the examination space, a magnetic gradient coil system for generating gradient magnetic fields superimposed to the static magnetic field, and at least one embodiment of the disclosed radio frequency channel-to-radio frequency antenna configurators or a combination thereof.

The method includes the following steps:

- selecting by a user a detail of the anatomy of the subject of interest to be imaged or a region of interest within the portion of the subject of interest to be imaged;
- selecting $n_{sel}$ radio frequency antennae out of the plurality of n radio frequency antennae, wherein each of the $n_{sel}$ radio frequency antennae is equipped with a current sensor, and the number $m_{sel}$ is less than the number $n_{sel}$;
- generating a plurality of pre-set coupling patterns formed by the $n_{sel}$ radio frequency antennae out of the plurality of n radio frequency antennae being radio frequency-connected to $m_{sel}$ radio frequency channels of the plurality of m radio frequency channels,
- consecutively establishing each of the generated pre-set coupling patterns and determining a measure of homogeneity of the radio frequency magnetic excitation field $B_1$ and a specific absorption rate SAR for each of the generated pre-set coupling patterns;
- selecting one of the generated pre-set coupling patterns under consideration of at least one out of the determined measure of homogeneity and the determined specific absorption rate with regard to a predefined threshold value for the measure of homogeneity and the specific absorption rate, respectively; and
- establishing the selected pre-set coupling pattern by the radio frequency channel-to-radio frequency antenna configurator.

The term *"generating a coupling pattern"*, as used in this application, shall be understood particularly as a potential assignment of each of the $n_{sel}$ radio frequency antennae to the $m_{sel}$ radio frequency channels which is suitable for an intended imaging.

The term *"establishing a coupling pattern"*, as used in this application, shall be understood particularly as realizing radio frequency connections between the $n_{sel}$ radio frequency antennae and the $m_{sel}$ radio frequency channels that correspond to the assignment represented by the coupling pattern.

Thereby, a pre-set and user-defined coupling pattern with a close-to-the-optimum radio frequency shimming in the presence of the subject of interest can be established in a situation in which less independent radio frequency sources than radio frequency antennae are available, which results in cost savings and relaxed requirements regarding allocated space. Furthermore, the method is useful for protecting the radio frequency antennae from being exposed to radio frequency power beyond their rating. Due to avoiding strong mutual coupling between radio frequency antennae, radio frequency power being fed to the radio frequency antennae is used in an efficient way, and electronic equipment of the magnetic resonance imaging system is protected from harmful conditions.

In another preferred embodiment, the method further comprises steps to be carried out after the step of selecting $n_{sel}$ radio frequency antennae out of the plurality of n radio frequency antennae (62, 64) of

- establishing a radio frequency connection between a selected one of the $n_{sel}$ radio frequency antennae and at least a selected one of the $m_{sel}$ radio frequency channels;
- providing radio frequency power to the selected radio frequency antenna by the selected radio frequency channel;
- if an induced current in a respective radio frequency antenna per radio frequency power provided to the selected radio frequency antenna exceeds a predetermined threshold value, eliminating at least one out of the respective radio frequency antenna and the selected radio frequency antenna from the step of generating a plurality of pre-set coupling patterns; and consecutively carrying out the preceding steps at least for the majority of the $n_{sel}$ radio frequency antennae.

In this way, a number of coupling patterns of the generated plurality of pre-set coupling patterns can be reduced by eliminating potential coupling patterns which technically are not considered appropriate, which can expedite the method by saving time in the step of consecutively establishing the generated preset coupling patterns.

In yet another aspect of the invention, an alternative method of operating a magnetic resonance imaging system is provided, wherein the magnetic resonance imaging system includes an examination space provided to position a subject of interest within, a main magnet for generating a substantially static magnetic field in the examination space, a magnetic gradient coil system for generating gradient magnetic fields superimposed to the static magnetic field, and at least one embodiment of the disclosed radio frequency channel-to-radio frequency antenna configurators or a combination thereof.

The alternative method includes the following steps:

- selecting a detail of the anatomy of the subject of interest to be imaged or a region of interest within the portion of the subject of interest to be imaged by a user;
- upon entry of the detail of the anatomy of the subject of interest to be imaged or the region of interest within the portion of the subject of interest to be imaged, selecting a pre-set and user-defined coupling pattern formed by $n_{sel}$ radio frequency antennae out of the plurality of n radio frequency antennae being radio frequency-connected to $m_{sel}$ radio frequency channels of the plurality of m radio frequency channels, wherein the number $m_{sel}$ is less than the number $n_{sel}$; and
- establishing the selected pre-set and user-defined coupling pattern by the radio frequency channel-to-radio frequency antenna configurator.

Thereby, a pre-set and user-defined coupling pattern with a close-to-the-optimum radio frequency shimming in the presence of the subject of interest can be quickly established once a portion of the anatomy of the subject of interest to be imaged or a selected region of interest within the portion of the subject of interest to be imaged has been selected.

The alternative method may further comprise a step of confirming by the user the selected pre-set and user-defined coupling pattern, wherein the step is carried out between the step of selecting the pre-set and user-defined coupling pattern and the step of establishing the selected pre-set and user-defined coupling pattern. By that, an improved ease of use for a user of the magnetic resonance imaging system including a radio frequency channel-to-radio frequency antenna configurator can be achieved. In a varied embodiment, the radio frequency channel-to-radio frequency antenna configurator may select more than one suitable pre-set and user-defined coupling patterns, which may be presented to the user simultaneously, or, alternatively, consecutively if the user declines a preceding pre-set and user-defined coupling pattern.

In yet another preferable embodiment of the alternative method, at least each of the $n_{sel}$ radio frequency antennae of the plurality of n radio frequency antennae is equipped with a current sensor, and the method comprises steps of

- selecting a specific absorption rate (SAR) model out of a number of predetermined specific absorption rate models, to be assigned to the detail of the anatomy of the subject of interest to be imaged or the region of interest within the portion of the subject of interest to be imaged;
- determine individual currents in the $n_{sel}$ radio frequency antennae upon activating the radio frequency channels of the radio frequency channel-to-radio frequency antenna configurator;
- estimating an expected specific absorption rate from the determined currents in the $n_{sel}$ radio frequency antennae, their stored individual transmit sensitivity distributions and the selected specific absorption rate model.

By that, a radio frequency monitoring during scan execution for ensuring to comply with specific absorption rate safety constraints in addition to a homogeneous radio frequency field in the presence of the subject of interest by radio frequency shimming can be accomplished.

In yet another aspect of the present invention, a software module for carrying out an embodiment of the methods of operating a magnetic resonance imaging system as disclosed herein or a combination thereof is provided. The method steps to be conducted are converted into a program code of the software module, wherein the program code is implementable in a memory unit of a control unit of the magnetic resonance imaging system and is executable by a processor unit of the control unit of the magnetic resonance imaging system. The control unit may be a control unit that is customary for controlling functions of a magnetic resonance imaging system. The control unit may alternatively be an additional control unit that is especially assigned to execute the method steps. The additional control unit may also be an integral part of the radio frequency channel-to-radio frequency antenna configurator.

The software module can enable a robust and reliable execution of the method and can allow for a fast modification of method steps and/or an adaptation of pre-set and user-defined coupling patterns.

BRIEF DESCRIPTION OF THE DRAWINGS

These and other aspects of the invention will be apparent from and elucidated with reference to the embodiments described hereinafter. Such embodiment does not necessarily represent the full scope of the invention, however, and reference is made therefore to the claims and herein for interpreting the scope of the invention.

In the drawings:

Fig. 1 is a schematic illustration of a part of an embodiment of a magnetic resonance imaging system in accordance with the invention,
Fig. 2 illustrates a radio frequency channel-to-radio frequency antenna configurator of the magnetic resonance imaging system pursuant to Fig. 1,
Fig. 3 shows a flowchart of a method in accordance with the invention of operating the magnetic resonance imaging system pursuant to Fig. 1,
FIG: 4 shows a flowchart of an alternative method in accordance with the invention of operating the magnetic resonance imaging system pursuant to Fig. 1, and
Fig. 5 is a schematic illustration of another embodiment of a radio frequency channel-to-radio frequency antenna configurator in accordance with the invention.

DETAILED DESCRIPTION OF EMBODIMENTS

In the following, several embodiments in accordance with the invention are disclosed. The individual embodiments are described with reference to a particular figure and are identified by a prefix number of the particular embodiment. Features whose function is the same or basically the same in all embodiments are identified by reference numbers made up of the prefix number of the embodiment to which it relates, followed by the number of the feature. If a feature of an embodiment is not described in the corresponding figure depiction, or a reference number mentioned in a figure depiction is not shown in the figure itself, reference should be made to the description of a preceding embodiment.

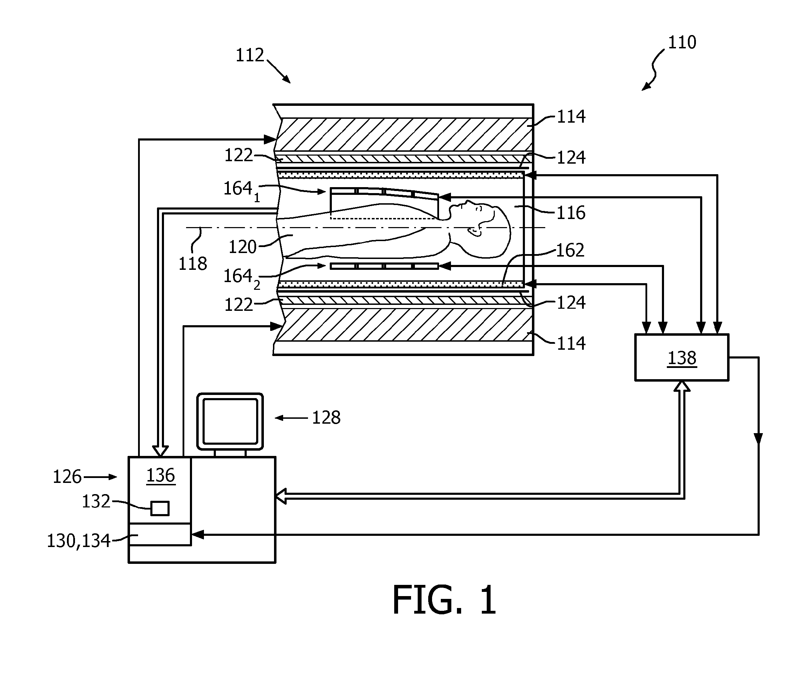

Fig. 1 shows a schematic illustration of a part of an embodiment of a magnetic resonance imaging system 110 configured for acquiring magnetic resonance signals from at least a portion of a subject of interest 120, usually a patient. The magnetic resonance imaging system 110 comprises a magnetic resonance scanner 112 having a main magnet 114. The main magnet 114 has a central bore that provides an examination space 116 around a center axis 118 for the subject of interest 120 to be positioned within, and is further provided for generating a substantially static magnetic field at least in the examination space 116. For clarity reasons, a customary table for supporting the subject of interest 120 has been omitted in Fig. 1. The substantially static magnetic field defines an axial direction of the examination space 116, aligned in parallel to the center axis 118. In principle, the invention is also applicable to any other type of magnetic resonance imaging systems providing an examination region within a static magnetic field.

Further, the magnetic resonance imaging system 110 comprises a magnetic gradient coil system 122 provided for generating gradient magnetic fields superimposed to the static magnetic field. The magnetic gradient coil system 122 is concentrically arranged within the bore of the main magnet 114.

The magnetic resonance imaging system 110 comprises a magnetic resonance imaging system control unit 126 provided to control functions of the magnetic resonance scanner 112 and the magnetic gradient coil system 122.

Further, the magnetic resonance imaging system 110 includes a radio frequency channel-to-radio frequency antenna configurator 138 for providing radio frequency connections between radio frequency channels and radio frequency antennae as will be described in the following. For briefness and better legibility, the radio frequency channel-to-radio frequency antenna configurator 138 will be denoted as just the "configurator 138" hereinafter.

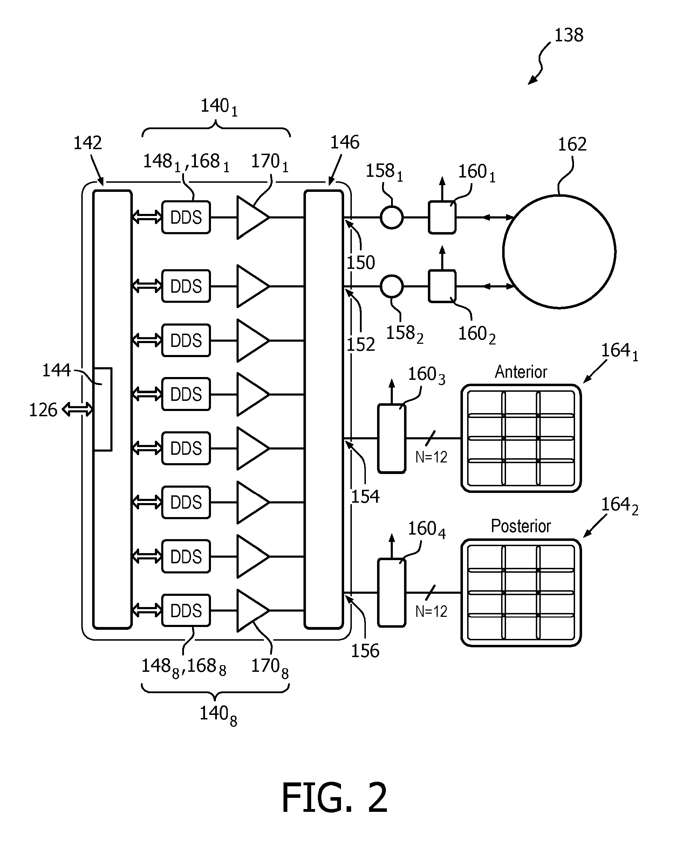

Referring now to Fig. 2, the configurator 138 comprises a plurality of n = 25 radio frequency antennae 162, 164 in total. Each of the radio frequency antennae 162, 164 is equipped with a current sensor (not shown in Fig. 2). One radio frequency antenna 162 of the plurality of n radio frequency antennae 162, 164 is designed as a whole-body coil that is provided for transmitting a radio frequency field to the examination space 116 during radio frequency transmit phases to excite nuclei within the subject of interest 120 for the purpose of magnetic resonance excitation. The whole-body coil is also provided to receive magnetic resonance signals from the excited nuclei during radio frequency receive phases which are distinct from the radio frequency transmit phases.

The whole-body coil has a center axis and, in the operational state, is arranged concentrically within the bore of the main magnet 114 such that the center axis of the whole-body coil and the center axis 118 of the magnetic resonance imaging system 110 coincide (Fig. 1). The whole-body coil is configured for dual channel radio frequency shimming, as is well known in the art. A cylindrical metal radio frequency shield 124 is arranged concentrically between the magnetic gradient coil system 122 and the whole-body coil.

Among the plurality of n = 25 radio frequency antennae 162, 164 of the configurator 138 are 24 radio frequency antennae 164 designed as local coils that are intended to be positioned proximal to the region of the subject of interest 120 to be imaged. The 24 local coils are configured for transmitting a radio frequency field during a first time period to excite nuclei within the portion of the subject of interest 120 to be imaged for the purpose of magnetic resonance excitation and for receiving magnetic resonance signals from the excited nuclei during a second time period which is distinct from the first time period.

The configurator 138 further includes a plurality of m = 8 independent radio frequency channels 140 (Fig. 2) which is less than the number n = 25 of radio frequency antennae 162, 164. Each of the m independent radio frequency channels 140 comprises a direct digital synthesizer (DDS) 168 and a radio frequency amplifier 170. Each of the direct digital synthesizers 168 is configured as a radio frequency input member 148 for generating radio frequency pulses and is connected to the radio frequency amplifier 170 of the respective radio frequency channel 140 for amplification purposes. The direct digital synthesizers 168 can be controlled via an interface and control unit 142 that is designed as an integral part of the configurator 138. An interface portion 144 of the interface and control unit 142 is connected to the magnetic resonance imaging system control unit 126 so as to control functions of the configurator 138 via the magnetic resonance imaging system control unit 126.

Furthermore, the configurator 138 comprises a radio frequency splitter/combiner and switch unit 146 that includes a number of radio frequency Butler matrix devices which are partially cascaded. The Butler matrix is known in the art (cf. Jesse Butler, Ralph Lowe, "Beam-Forming Matrix Simplifies Design of Electronically Scanned Antennas", Electronic Design, volume 9, pp. 170-173, 1961) and shall therefore not be discussed in much detail herein.

There are several ways to design a switchable power splitter for the disclosed applications. For example, the Butler matrix may consist of several hybrids, arranged in stages (e.g. 3 for 8 channels), which are typically made of two cables of $\lambda/8$ length connected with a capacitor of $1/(\omega Z_0)$ at both ends ($\omega$: angular frequency, $Z_0$: normalization impedance). Such capacitors can be made switchable, so that the hybrid function can be switched on and off while all ports remain matched to the normalization impedance $Z_0$. In addition, the cable lengths in all connections of the individual combiner stages can be made electronically adjustable such that phases can be controlled.

In principle, any other splitter/combiner member that appears suitable to the person skilled in the art can be employed in the radio frequency splitter/combiner and switch unit.

The whole-body coil is connected to a first output port 150 and a second output port 152 of the radio frequency splitter/combiner and switch unit 146 via optional circulators $158_1$, $158_2$ and radio frequency transmit/receive switch $160_1$, $160_2$, respectively. The optional circulators $158_1$, $158$ function as a one-way paths for the radio frequency and serve as dumps for the portion of the radio frequency energy that is reflected at the radio frequency transmit/receive switches $160_1$, $160_2$ and/or the whole-body coil.

Radio frequency power is provided at the first output port 150 and the second output port 152 of the radio frequency splitter/combiner and switch unit 146 to feed radio frequency power of a magnetic resonance radio frequency to the whole-body coil via the radio frequency transmit/receive switches $160_1$, $160_2$ during the radio frequency transmit phases. During radio frequency receive phases, the radio frequency transmit/receive switches $160_1$, $160_2$ direct the magnetic resonance signals acquired by the whole-body coil to an magnetic resonance image reconstruction unit 136 residing in the magnetic resonance imaging system control unit 126. This technique is well known to the one skilled in the art and thus does not need to be described in further detail herein.

The 24 radio frequency antennae 164 that are designed as local coils are grouped into two groups $164_1$, $164_2$ of twelve coils each. The first group $164_1$ of twelve local coils is configured as an array of coils to be positioned in an anterior position of the subject of interest 120. Radio frequency power is fed to the first group $164_1$ of twelve local coils by third output ports 154 of the radio frequency combiner and system switch unit 146 via an integrated radio frequency combiner and radio frequency transmit/receive switch $160_3$.

The second group $164_2$ of twelve local coils is configured as an array of coils to be positioned in a posterior position of the subject of interest 120. Radio frequency power is fed to the second group $164_2$ of twelve local coils by fourth output ports 156 of the radio frequency combiner and system switch unit 146 via another integrated radio frequency combiner and radio frequency transmit/receive switch $160_4$.

The radio frequency splitter/combiner and switch unit 146 is provided for semi-automatically establishing a preset and user-defined coupling pattern formed by $n_{sel}$ radio frequency antennae out of the plurality of n = 25 radio frequency antennae 162, 164 being radio frequency-connected to $m_{sel}$ radio frequency channels of the plurality of m = 8 radio frequency channels 140, wherein the number $m_{sel}$ is less than the number $n_{sel}$. A transition time from a first pre-set and user-defined coupling pattern to a second pre-set and user-defined coupling pattern that is distinct from the first pre-set and user-defined coupling pattern in a majority of connections of the first pre-set and user-defined coupling pattern, is less than a millisecond.

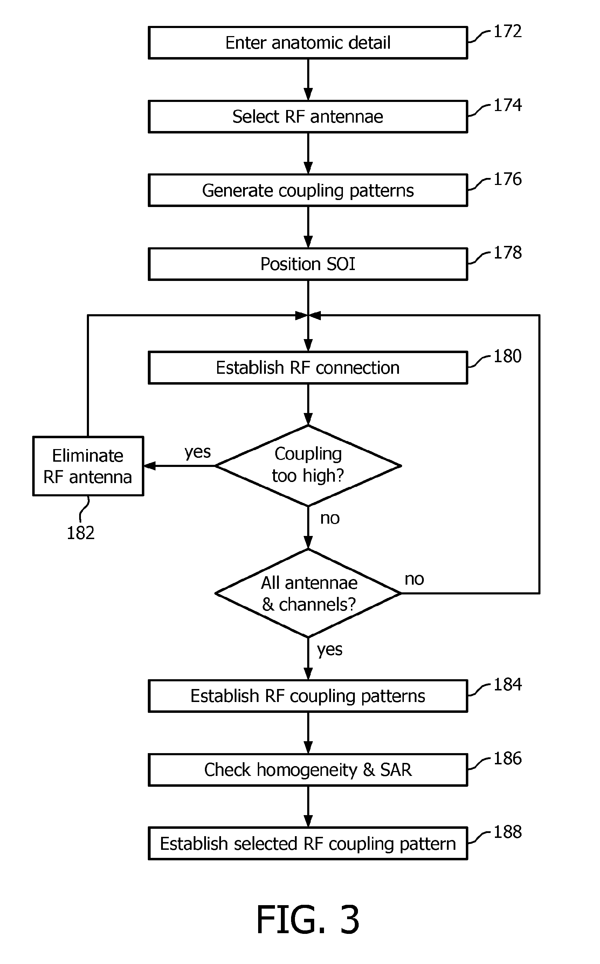

An embodiment of a method of operating the magnetic resonance imaging system 110 pursuant to Fig. 1, including the method of semi-automatically establishing a pre-set and user-defined coupling pattern, will be presented in the following with reference to Fig. 3, showing a flowchart of the method which is in accordance with the invention.

In preparation of establishing the pre-set and user-defined coupling pattern, it shall be understood that radio frequency antennae 162, 164 are connected to the configurator 138 as shown in Fig. 2, and that the magnetic resonance system control unit 126 is connected to the interface and control unit 142 and that all involved units and devices are in an operational state.

In order to be able to carry out the method as a specific operation of the magnetic resonance imaging system 110, the magnetic resonance imaging system control unit 126 comprises a software module 134 (Fig. 1). The method steps to be conducted are converted into a program code of the software module 134, wherein the program code is implementable in a memory unit 130 of the magnetic resonance imaging system control unit 126 and is executable by a processor unit 132 of the magnetic resonance imaging system control unit 126.

In a first step 172 of the method, a detail of the anatomy of the subject of interest 120 to be imaged or a region of interest within the portion of the subject of interest 120 to be imaged is selected by a user from a menu displayed at a monitor unit 128 of the magnetic resonance system control unit 126 or entered into it by the user via a human interface device.

In a second step 174 of the method, upon entry of the detail of the anatomy of the subject of interest 120 to be imaged or the region of interest within the portion of the subject of interest 120 to be imaged, the magnetic resonance system control unit 126 automatically selects $n_{sel}$ radio frequency antennae out of the plurality of $n = 25$ radio frequency antennae 162, 164, wherein the number $m_{sel}$ is less than the number $n_{sel}$. As mentioned before, each of the $n_{sel}$ radio frequency antennae is equipped with a current sensor.

The third step 176 is automatically carried out by the magnetic resonance system control unit 126, which generates a plurality of pre-set coupling patterns formed by the $n_{sel}$ radio frequency antennae out of the plurality of n radio frequency antennae that are radio frequency-connected to $m_{sel}$ radio frequency channels of the plurality of m radio frequency channels 140.

In another step 178 of the method, the subject of interest 120 is positioned within the examination space 116 to a position relative to the radio frequency antennae 162, 164 that is, by experience, considered as being close to an optimum with regard to radio frequency shimming and magnetic resonance imaging.

Then, in the next step 180, the magnetic resonance system control unit 126 automatically establishes a radio frequency connection between a selected one of the $n_{sel}$ radio frequency antennae 162, 164 and a selected one of the $m_{sel}$ radio frequency channels 140, and radio frequency power is provided to the selected radio frequency antenna 162, 164 by the selected radio frequency channel 140, controlled by the magnetic resonance system control unit 126.

If an induced current in a respective radio frequency antenna 162, 164 per radio frequency power provided to the selected radio frequency antenna 162, 164 exceeds a predetermined threshold value, the magnetic resonance system control unit 126 in another step 182 eliminates the respective radio frequency antenna 162, 164 from further considerations.

Steps 180 and 182 are consecutively carried out until a majority of the $n_{sel}$ radio frequency antennae 162, 164 has been treated. Due to the symmetry of mutual inductance, all independent terms of mutual coupling are covered in this way.

Steps 180 and 182 are then consecutively conducted for a next one of the $m_{sel}$ radio frequency channels 140 until all of the $m_{sel}$ radio frequency channels 140 have been treated.

In the next step 184, controlled by the magnetic resonance system control unit 126, the remaining generated pre-set coupling patterns are established consecutively, and a measure of homogeneity of the radio frequency magnetic excitation field $B_1$ and a specific absorption rate SAR is determined for each of the generated pre-set coupling patterns.

In the following step 186 then, one of the remaining generated pre-set coupling patterns is selected by the magnetic resonance system control unit 126, under consideration of the determined measure of homogeneity and the determined measure of SAR with regard to predefined threshold values for the measure of homogeneity and the SAR, respectively. The threshold values have been stored in the memory unit 130 of the magnetic resonance imaging system control unit 126. The magnetic resonance imaging system control unit 126 is configured for applying a formula to each pair of determined measure of homogeneity and determined SAR, wherein the formula comprises a weighted sum of the measure of homogeneity and the inverse of the SAR.

The remaining generated pre-set coupling pattern that was selected by the magnetic resonance system control unit 126 is then shown on the monitor unit 128 to the user and can be either confirmed or rejected by the user. In case of rejection, the coupling pattern having the next best value from applying the formula is displayed on the monitor unit 128. In case of confirmation by the user, the selected pre-set and user-defined coupling pattern is established by the configurator 138 in another step 188. This step 188 is carried out by the magnetic resonance system control unit 126 controlling the configurator 138 via the interface portion 144 of the interface and control unit 142, finalizing the preparation of the radio frequency channel-to-radio frequency antenna configurator 138 for magnetic resonance imaging.

In this way, the pre-set and user-defined coupling pattern is semi-automatically established in dependence of a portion of the anatomy of the subject of interest 120 to be imaged or the region of interest within the portion of the subject of interest 120 to be imaged.

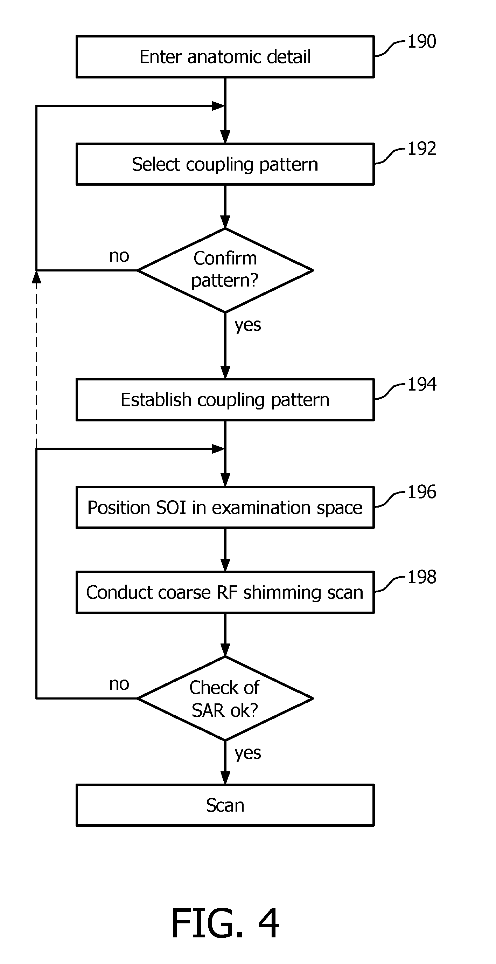

An alternative embodiment of a method of operating the above-described magnetic resonance imaging system 110 pursuant to Fig. 1, including a method of semi-automatically establishing a pre-set and user-defined coupling pattern, will be presented next with reference to Fig. 4, showing a flowchart of the method which is in accordance with the invention.

In preparation of establishing the pre-set and user-defined coupling pattern, it shall again be understood that radio frequency antennae 162, 164 are connected to the configurator 138 as shown in Fig. 2, and that the magnetic resonance system control unit 126 is connected to the interface and control unit 142 and that all involved units and devices are in an operational state.

In order to be able to carry out the method as a specific operation of the magnetic resonance imaging system 110, the magnetic resonance imaging system control unit 126 comprises the software module 134 implemented and executable in the same manner as described earlier for the first embodiment of the method. The steps of the alternative method to be conducted are converted into a program code of the software module 134, wherein the program code is implementable in a memory unit 130 of the magnetic resonance imaging system control unit 126 and is executable by a processor unit 132 of the magnetic resonance imaging system control unit 126.

In a first step 190 of the alternative method, a detail of the anatomy of the subject of interest 120 to be imaged or a region of interest within the portion of the subject of interest 120 to be imaged is selected by the user from a menu displayed at the monitor unit 128 of the magnetic resonance system control unit 126 or entered into it by the user via the human interface device.

In a second step 192 of the method, upon entry of the detail of the anatomy of the subject of interest 120 to be imaged or the region of interest within the portion of the subject of interest 120 to be imaged, the magnetic resonance system control unit 126 selects a pre-set and user-defined coupling pattern formed by $n_{sel}$ radio frequency antennae out of the plurality of n = 25 radio frequency antennae 162, 164 being radio frequency-connected to $m_{sel}$ radio frequency channels of the plurality of m = 8 radio frequency channels 140, wherein the number $m_{sel}$ is less than the number $n_{sel}$.

The selected pre-set and user-defined coupling pattern is then displayed at the monitor unit 128 and can be either confirmed or rejected by the user. In case of rejection, another pre-set and user-defined coupling pattern from a list of pre-set and user-defined coupling patterns is displayed at the monitor unit 128. In case of confirmation by the user, the selected pre-set and user-defined coupling pattern is established by the configurator 138 in a third step 194. The third step 194 is carried out by the magnetic resonance system control unit 126 controlling the configurator 138 via the interface portion 144 of the interface and control unit 142.

In this way, the pre-set and user-defined coupling pattern is semi-automatically established in dependence of a portion of the anatomy of the subject of interest 120 to be imaged or the region of interest within the portion of the subject of interest 120 to be imaged.

The list of pre-set and user-defined coupling patterns may have been generated from earlier calibration measurements with the plurality of n = 25 radio frequency antennae 162, 164, and resides in the memory unit 130 of the magnetic resonance system control unit 126 so that the list can readily be updated with results from new calibration data. The calibration measurements may have been carried out with human volunteers of different sizes (small, medium, large). A short description of the mathematical concept that underlies the calibration measurements is presented below in an addendum. A size category of the subject of interest 120 to be imaged may as well be entered into the magnetic resonance system control unit 126 by the user when determining the detail of the anatomy of the subject of interest 120. By that, the selected coupling pattern is very likely to fulfill the radio frequency shimming requirements, as among subjects of interest 120 of similar size, there is little variation of coupling pattern-determining parameters.

The selected coupling pattern may require a re-positioning of one or more local coils by the user or an assistant.

In the next step 196 of the method, the subject of interest 120 is placed within the examination space 116 to a position relative to the radio frequency antennae 162, 164 that is considered to be optimum with regard to radio frequency shimming and magnetic resonance imaging. Then, in another step 198 of the method, a coarse radio frequency shimming scan is conducted for confirming the suitability of the established coupling pattern with regard to $B_1$ radio frequency field mapping, radio frequency shimming adjustment and compliance with specific absorption rate (SAR) constraints. To this end, a specific absorption rate model is used that is assigned to the detail of the anatomy of the subject of interest 120 or the region of interest within the portion of the subject of interest 120 that has been selected by the user. The used absorption rate model is one out of a list of predetermined specific absorption rate models, each of which is assigned to at least one detail of the anatomy of the subject of interest 120 or at least one region of interest within the portion of the subject of interest 120. From determined individual currents in the $n_{sel}$ selected radio frequency antennae 162, 164 upon activating the radio frequency channels 140 of the configurator 138, their known and stored individual transmit coil sensitivity distributions, and on the basis of the assigned specific absorption rate model, an expected specific absorption rate is estimated. If the estimated expected specific absorption rate exceeds a threshold value that is stored in the memory unit 130 of the magnetic resonance imaging system control unit 126, the user is notified by a message on the display of the monitor unit 128 that an imaging scan cannot be carried out, and one or both of the local coil placements relative to the subject of interest 120 and the position of the subject of interest 120 within the examination space 116 need to be revised in a radio frequency fine shim step. If the estimated expected specific absorption rate falls below the threshold value, the user is notified by another message on the display of the monitor unit 128 that the imaging scan can be performed.

The person skilled in the art will appreciate that there is a plurality of potential alternative embodiments of methods of operating the above-described magnetic resonance imaging system 110 pursuant to Fig. 1, including a method of semi-automatically establishing a pre-set and user-defined coupling pattern, by combining above disclosed method steps. Having a plurality of radio frequency antennae available for specific application, such as a head and a spine array, opens a wide parameter space with multiple potential coupling patterns.

Not all the potential coupling patterns might be reasonable for reasons of strong mutual coupling between radio frequency antennae, of some radio frequency antennae not contributing to the radio frequency magnetic excitation field $B_1$, of causing inhomogeneity in the radio frequency magnetic excitation field $B_1$, or of causing excessive SAR. Thus, useless radio frequency antennae need to be excluded, and the best combination of $n_{sel}$ radio frequency antennae and $m_{sel}$ radio frequency channels has to be found after a step of selecting a detail of the anatomy of the subject of interest to be imaged, and after a step of generating a plurality of coupling patterns.

Often, the step of excluding radio frequency antennae has to happen within a small amount of time. Therefore, in a next step radio frequency measurements are carried out by applying short radio frequency pulses to determine mutual coupling and radio frequency antenna loading for then excluding some of the radio frequency antennae.

In another step then, $B_1$-mapping is conducted to determine the radio frequency magnetic excitation field $B_1$ by the individual radio frequency antennae, which takes about one second per map, either by driving each one of the radio frequency antennae individually or by simultaneously driving various linear combinations of radio frequency antennae via the Butler matrix and switch, exploiting its linearity.

From the maps of the radio frequency magnetic excitation field $B_1$, an optimum radio frequency shim set can be calculated in another step. Considering that there are not enough radio frequency channels, this might result in a close-to-optimum shim set, using the available amplifiers. In an iterative next step, some of the radio frequency antennae that are found not to support the optimum shim set are eliminated. In case that starting values for $B_1$ mapping do not fit well enough in terms of radio frequency power per radio frequency antenna/Butler matrix input, then a second calibration and mapping run is required.

In the following step, the SAR is checked, for instance via SAR modeling in radio frequency simulations, or by direct SAR calculation based on the $B_1$ maps, and further radio frequency antenna eliminated when exceeding a maximum tolerable SAR threshold.

The determination of an optimum shim set might also be done in a single step, wherein the shim set with the most homogeneous radio frequency excitation field $B_1$ and the lowest SAR is calculated.

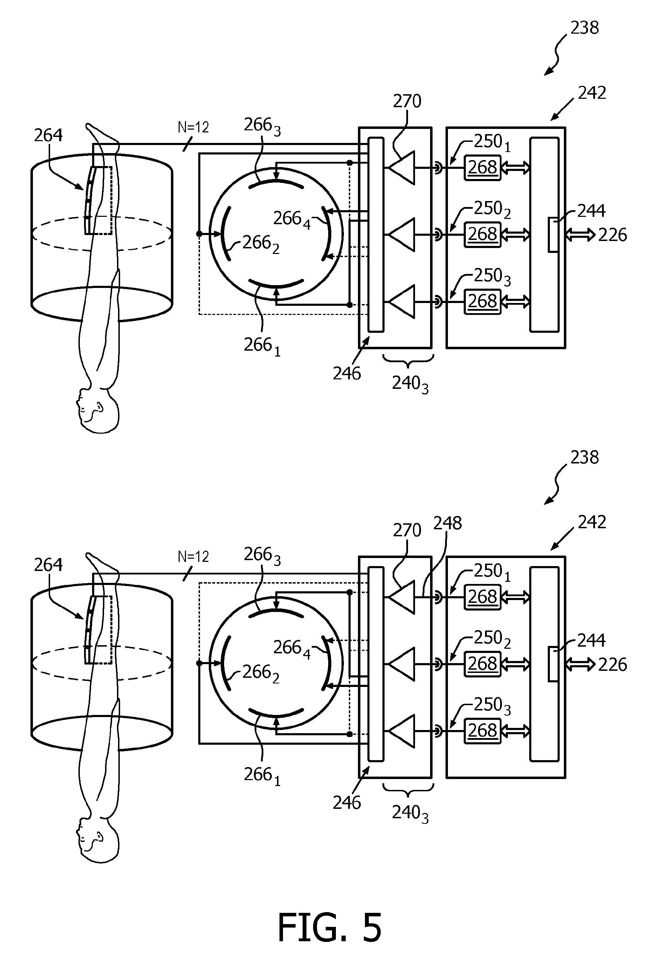

Another embodiment of a radio frequency channel-to-radio frequency antenna configurator 238 in accordance with the invention is schematically illustrated in Fig. 5. Only features differing from the embodiment pursuant to Figs. 1 and 2 will be described. For features of the second embodiment that are not described hereinafter, reference is made to the description of the first embodiment.

The configurator 238 comprises a plurality of m' = 3 independent radio frequency channels 240, each radio frequency channel 240 including a radio frequency input member 248 formed as a female Type N radio frequency connector and a downstream radio frequency amplifier 270. Each of the female Type N radio frequency connectors is configured to be fed radio frequency power to from an independent radio frequency source.

Differing from the embodiment pursuant to Figs. 1 and 2, an interface and control unit 242 includes three direct digital synthesizers (DDS) 268 configured for generating radio frequency pulses. Output ports $250_1$, 2502, $250_3$ of the direct digital synthesizers 268 are formed as male Type N radio frequency connectors that are intended to be connected to the female Type N radio frequency connectors of a respective radio frequency channel 240 of the configurator 238. The direct digital synthesizers 268 can be controlled by the magnetic resonance system control unit 226 via the interface and control unit 242. To this end, an interface portion 244 of the interface and control unit 242 is connected to the magnetic resonance imaging system control unit 226.

Further, the configurator 238 includes a plurality of n' = 16 radio frequency antennae 264, 266, twelve out of which are identical to the first group of local coils to be positioned in an anterior position of the subject of interest 220. The other four radio frequency antennae $266_1$-$266_4$ out of the plurality of n' = 16 radio frequency antennae 264, 266 are designed as body coil members of a bird-cage type whose members can be driven independently with regard to radio frequency current and phase, as is known in the art. In Fig. 5, the four body coil members are schematically shown as a top, bottom, left, and right member for illustration purposes.

A radio frequency splitter/combiner and switch unit 246, arranged between the radio frequency amplifiers 270 and the radio frequency antennae 264, 266, is in principle identical to the one of the embodiment pursuant to Figs. 1 and 2 except for a number of output ports.

The left part of Fig. 5 shows a pre-set and user-defined coupling pattern that the radio frequency splitter/combiner and switch unit 246 has semi-automatically established after confirmation by a user, and which has been selected from the user's input that a portion of the anatomy of the subject of interest 220 that is intended to be imaged is the subject's abdomen. A magnetic resonance scan plane is indicated by a dashed line.

The right part of Fig. 5 shows a pre-set and user-defined coupling pattern that the radio frequency splitter/combiner and switch unit 246 has semi-automatically established after confirmation by the user, and which has been selected from the user's input that a portion of the anatomy of the subject of interest 220 that is intended to be imaged is the subject's legs. Again, a magnetic resonance scan plane is indicated by a dashed line.

For fast magnetic resonance imaging, e.g. for submillisecond imaging or ultrashort echo imaging, the body coil can be switched between a status of tuned radio frequency transmission and a status of tuned radio frequency reception in less than a millisecond, allowing the local coils in a status of radio frequency reception being tuned to the magnetic resonance frequency while the body coil is in the status of tuned radio frequency reception.

Addendum: Mathematical concept of pre-set and user-defined coupling patterns

For any given anatomy like head, heart, abdomen, or legs, transmit coil sensitivity distributions ($B_1^+$ maps) of all individual radio frequency antennae can be obtained by appropriate measurements. These transmit coil sensitivity distributions can be defined as an average over many representative patients. The transmit coil sensitivity distributions are anatomy-dependent and can be transformed into any virtual coil system, e.g. into an appropriate eigenmode system, using mathematical transformations.

The real physical coils can be described by a matrix C, where the rows of C form vectors that contain the spatial sensitivities of the individual transmit coils. The coil sensitivity matrix C can for instance be given in its singular values decomposed (SVD) representation. Here the SVD is only one example.

$$C = U \Sigma V^H \tag{1}$$

Here the matrix $\Sigma$ contains the singular values, which basically correspond to the eigenvalues of the coil sensitivity matrix C. The unitary matrix U, or more precisely the Hermitian of U ($U^H$), acts as a projection matrix mapping the real physical transmit coil sensitivities of C onto the virtual ones, the eigenmodes described by E:

$$E = U^H C = U^{-1} C = \Sigma V^H \tag{2}$$

The eigenmode distribution will differ for the individual anatomies. Furthermore, the eigenmodes can be ranked according to their contribution to the properties of the entire coil system, by the singular values given in matrix $\Sigma$. This ranking offers the opportunity to do without the less important ones in a quantified manner, without sacrificing much of the array performance. If there are fewer amplifiers than coils available, radio frequency transmission should be done with the most important eigenmodes. This can mathematically be described by the operator R, similar to the unity matrix which has zeros at the positions of the virtual coil modes, those can be discarded for a given application, and Eq. (3) can be obtained:

$$E' = (R U^H) C \tag{3}$$

E' denotes the reduced virtual-coil system. So one can consider E' as the driving ports of the radio frequency coil attached to the m radio frequency amplifiers, mapped via ($RU^H$) to outputs, the n individual coils elements (m < n).

Based on coarse *a priori* information about the coil sensitivities of a transmit coil array, if a certain anatomical region is inside the examination space, the linear transforms to obtain the important virtual coils modes E' can be estimated. Either prior to scanning, if technically feasible, or already during the manufacturing process, as pre-sets, the settings of the anatomy-dependent switching matrix can be adjusted. So the anatomy-dependent pre-set of the mapping matrix ($R U^H$) forms an adjusted set of basic functions to perform radio frequency shimming at this anatomy with a limited number of amplifiers with an optimum performance. In this way one could optimize an encoding capability of the transmit coil array to the given application.

It is noted that in case of reception, meaning that the coil array is used as a transmit/receive coil array, also only these modes are available. Based on the m individual received signals one can decompose the individual receive coil signal using the inverse of Eq. (3) or one can form all kinds of desired superpositions or other virtual modes.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

REFERENCE SYMBOL LIST

| | | | |
|---|---|---|---|
| 10 | magnetic resonance imaging system | 52 | second output port |
| 12 | magnetic resonance scanner | 54 | third output ports |
| 14 | main magnet | 56 | fourth output ports |
| 16 | examination space | 58 | circulator |
| 18 | center axis | 60 | radio frequency transmit/receive switch |
| 20 | subject of interest | 62 | radio frequency antenna (BC) |
| 22 | magnetic gradient coil system | 64 | radio frequency antenna (LC) |
| 24 | radio frequency shield | 66 | radio frequency antenna (BCC) |
| 26 | magnetic resonance imaging system control unit | 68 | direct digital synthesizer |
| 28 | monitor unit | 70 | radio frequency amplifier |
| 30 | memory unit | 72 | step of selecting anatomy detail |
| 32 | processor unit | 74 | step of selecting antennae |
| 34 | software module | 76 | step of generating coupling patterns |
| 36 | magnetic resonance image reconstruction unit | 78 | step of positioning SOI |
| 38 | radio frequency channel-to-radio frequency antenna configurator | 80 | step of establishing radio frequency connection |
| 40 | radio frequency channel | 82 | step of eliminating radio frequency antenna |
| 42 | interface and control unit | 84 | step of establishing coupling pattern/determining measures |
| 44 | interface portion | 86 | step of selecting coupling pattern |
| 46 | radio frequency splitter/combiner and switch unit | 88 | step of establishing coupling pattern |
| 48 | radio frequency input member | 90 | step of selecting anatomy detail |
| 50 | first output port | 92 | step of selecting coupling pattern |
| | | 94 | step of establishing coupling pattern |
| | | 96 | step of positioning SOI |
| | | 98 | step of coarse radio frequency shimming scan |

**Claims**

1. A radio frequency channel-to-radio frequency antenna configurator (38) for providing radio frequency connections between radio frequency channels (40) and radio frequency antennae (62,64,66), for use in a magnetic resonance imaging system (10) configured for acquiring magnetic resonance signals from at least a portion of a subject of interest (20), comprising:

   - a plurality of m independent radio frequency channels (40), each radio frequency channel (40) including at least a radio frequency input member (48) and a radio frequency amplifier (70);
   - a plurality of n radio frequency antennae (62, 64), wherein each radio frequency antenna (62, 64) is provided at least for transmitting a radio frequency field to excite nuclei within the portion of the subject of interest (20) for the purpose of magnetic resonance excitation,
   wherein the number m is less than the number n;
   - a radio frequency splitter/combiner and switch unit (46) that is configured for semi-automatically establishing a pre-set and user-defined coupling pattern formed by $n_{sel}$ radio frequency antennae out of the plurality of n radio frequency antennae (62, 64) being radio frequency-connected to $m_{sel}$ radio frequency channels of the plurality of m radio frequency channels (40), wherein the number $m_{sel}$ is less than the number $n_{sel}$.

2. The radio frequency channel-to-radio frequency antenna configurator (38) as claimed in claim 1, wherein the pre-set and user-defined coupling pattern is semi-automatically established in dependence of a portion of the anatomy of the subject of interest (20) to be imaged or the region of interest within the portion of the subject of interest (20) to be imaged.

3. The radio frequency channel-to-radio frequency antenna configurator (38) as claimed in claim 1 or 2, wherein at least one radio frequency antenna of the plurality of n radio frequency antennae (62, 64) is configured as a local coil.

4. The radio frequency channel-to-radio frequency antenna configurator (38) as claimed in any one of the preceding claims, wherein at least one radio frequency antenna of the plurality of n radio frequency antennae (62, 64) is configured as a body coil.

5. The radio frequency channel-to-radio frequency antenna configurator (38) as claimed in any one of the preceding claims, wherein at least one radio frequency antenna of the plurality of n radio frequency antennae (62, 64) is configured for transmitting radio frequency energy for excitation of nuclei during a first time period and for receiving magnetic resonance signals from the excited nuclei during a second time period which is distinct from the first time period.

6. The radio frequency channel-to-radio frequency antenna configurator (38) as claimed in any one of the preceding claims, wherein a transition time from a first pre-set and user-defined coupling pattern to a second pre-set and user-defined coupling pattern that is distinct from the first pre-set and user-defined coupling pattern in a majority of connections of the first pre-set and user-defined coupling pattern, is less than a millisecond.

7. The radio frequency channel-to-radio frequency antenna configurator (38) as claimed in any one of the preceding claims, wherein the radio frequency splitter/combiner and switch unit (46) comprises at least one Butler matrix.

8. A magnetic resonance imaging system (10) configured for acquiring magnetic resonance signals from at least a portion of a subject of interest (20), comprising:

- an examination space (16) provided to position the subject of interest (20) within;
- a main magnet (14) for generating a substantially static magnetic field in the examination space (16);
- a magnetic gradient coil system (22) for generating gradient magnetic fields superimposed to the static magnetic field; and
- at least one radio frequency channel-to-radio frequency antenna configurator (38) as claimed in any one of claims 1 to 7.

9. A method of operating a magnetic resonance imaging system (10) as claimed in claim 8, the method including following steps:

- selecting (72) by a user a detail of the anatomy of the subject of interest (20) to be imaged or a region of interest within the portion of the subject of interest (20) to be imaged;
- selecting (74) $n_{sel}$ radio frequency antennae out of the plurality of n radio frequency antennae (62, 64), wherein each of the $n_{sel}$ radio frequency antennae is equipped with a current sensor, and the number $m_{sel}$ is less than the number $n_{sel}$;
- generating (76) a plurality of pre-set coupling patterns formed by the $n_{sel}$ radio frequency antennae out of the plurality of n radio frequency antennae (62, 64) being radio frequency-connected to $m_{sel}$ radio frequency channels of the plurality of m radio frequency channels (40),
- consecutively establishing (84) each of the generated pre-set coupling patterns and determining a measure of homogeneity of the radio frequency magnetic excitation field $B_1$ and a specific absorption rate SAR for each of the generated pre-set coupling patterns;
- selecting (86) one of the generated pre-set coupling patterns under consideration of at least one out of the determined measure of homogeneity and the determined specific absorption rate with regard to a predefined threshold value for the measure of homogeneity and the specific absorption rate, respectively; and
- establishing (88) the selected pre-set coupling pattern by the radio frequency channel-to-radio frequency antenna configurator (38).

10. The method as claimed in claim 9, further comprising steps to be carried out after the step of selecting (74) $n_{sel}$ radio frequency antennae out of the plurality of n radio frequency antennae (62, 64) of

- establishing (80) a radio frequency connection between a selected one of the $n_{sel}$ radio frequency antennae and at least a selected one of the $m_{sel}$ radio frequency channels;
- providing radio frequency power to the selected radio frequency antenna (62, 64) by the selected radio frequency channel (40);
- if an induced current in a respective radio frequency antenna per radio frequency power provided to the selected radio frequency antenna (62, 64) exceeds a predetermined threshold value, eliminating (82) at least one out of the respective radio frequency antenna (62, 64) and the selected radio frequency antenna (62, 64) from the step (76) of generating a plurality of pre-set coupling patterns; and
- consecutively carry out the preceding steps at least for the majority of the $n_{sel}$ radio frequency antennae.

11. A method of operating a magnetic resonance imaging system (10) as claimed in claim 8, the method including the following steps:

- selecting (90) a detail of the anatomy of the subject of interest (20) to be imaged or a region of interest within the portion of the subject of interest (20) to be imaged by a user;
- upon entry of the detail of the anatomy of the subject of interest (20) to be imaged or the region of interest within the portion of the subject of interest (20) to be imaged, selecting (92) a pre-set and user-defined coupling pattern formed by $n_{sel}$ radio frequency antennae out of the plurality of n radio frequency antennae (62, 64) being radio frequency-connected to $m_{sel}$ radio frequency channels of the plurality of m radio frequency channels (40), wherein the number $m_{sel}$ is less than the number $n_{sel}$; and
- establishing (94) the selected pre-set and user-defined coupling pattern by the radio frequency channel-to-radio frequency antenna configurator (38).

12. The method as claimed in claim 11, further comprising a step of confirming by the user the selected pre-set and user-defined coupling pattern, wherein the step is carried out between the step of selecting (90) the pre-set and user-defined coupling pattern and the step of establishing (94) the selected pre-set and user-defined coupling pattern.

13. The method as claimed in claim 11 or 12, wherein at least each of the $n_{sel}$ radio frequency antennae of the plurality of n radio frequency antennae (62, 64) is equipped with a current sensor, and the method comprises steps of

- selecting a specific absorption rate model out of a number of predetermined specific absorption rate models, to be assigned to the detail of the anatomy of the subject of interest (20) to be imaged or the region of interest within the portion of the subject of interest (20) to be imaged;
- determine individual currents in the $n_{sel}$ radio frequency antennae upon activating the radio frequency channels (40) of the radio frequency channel-to-radio frequency antenna configurator (38);
- estimating an expected specific absorption rate from the determined currents in the $n_{sel}$ radio frequency antennae, their stored individual transmit coil sensitivity distributions and the selected SAR model.

14. A software module (34) for carrying out a method as claimed in any one of claims 9 to 13 of operating a magnetic resonance imaging system (10), wherein the method steps (90, 92, 94) to be conducted are converted into a program code of the software module (34), wherein the program code is implementable in a memory unit (30) of a control unit (26) of the magnetic resonance imaging system (10) and is executable by a processor unit (32) of the control unit (26) of the magnetic resonance imaging system.

FIG. 1

FIG. 2

Enter anatomic detail — 172

Select RF antennae — 174

Generate coupling patterns — 176

Position SOI — 178

Establish RF connection — 180

Eliminate RF antenna — 182

yes

Coupling too high?

no

All antennae & channels?

no

yes

Establish RF coupling patterns — 184

Check homogeneity & SAR — 186

Establish selected RF coupling pattern — 188

FIG. 3

Enter anatomic detail — 190

Select coupling pattern — 192

no ← Confirm pattern?

yes

Establish coupling pattern — 194

Position SOI in examination space — 196

Conduct coarse RF shimming scan — 198

no ← Check of SAR ok?

yes

Scan

# FIG. 4

FIG. 5

Europäisches
Patentamt

European
Patent Office

Office européen
des brevets

# EUROPEAN SEARCH REPORT

**Application Number**

EP 13 19 7707

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/223706 A1 (HETHERINGTON HOBY P [US] ET AL) 6 September 2012 (2012-09-06) * paragraph [0317] - paragraph [0332] * * figures 6A-9 * | 1-9, 11-14 | INV. G01R33/36 G01R33/565 |
| X | US 2008/218168 A1 (TAKAGI MITSUO [JP]) 11 September 2008 (2008-09-11) * paragraph [0037] - paragraph [0101] * * figures 1-6 * | 1-9, 11-14 | |
| X | US 2005/134270 A1 (DUMOULIN CHARLES [US] ET AL) 23 June 2005 (2005-06-23) * paragraph [0027] - paragraph [0038] * * figures 3-8 * | 1-8,11, 12,14 | |
| A | GRAESSLIN I ET AL: "REAL-TIME SAR MONITORING TO ENSURE PATIENT SAFETY FOR PARALLEL TRANSMISSION SYSTEMS", PROCEEDINGS OF THE INTERNATIONAL SOCIETY FOR MAGNETIC RESONANCE IN MEDICINE, ISMRM, JOINT ANNUAL MEETING ISMRM-ESMRMB, BERLIN, GERMANY, 19-25 MAY 2007, 5 May 2007 (2007-05-05), page 1086, XP040600265, * the whole document * | 1-14 | **TECHNICAL FIELDS SEARCHED (IPC)** G01R |
| A | SHUO FENG ET AL: "Coil reduction in parallel excitation with large array", 2010 ANNUAL INTERNATIONAL CONFERENCE OF THE IEEE ENGINEERING IN MEDICINE AND BIOLOGY SOCIETY : (EMBC 2010) ; BUENOS AIRES, ARGENTINA, 31 AUGUST - 4 SEPTEMBER 2010, IEEE, PISCATAWAY, NJ, USA, 31 August 2010 (2010-08-31), pages 3313-3316, XP032109232, DOI: 10.1109/IEMBS.2010.5627495 ISBN: 978-1-4244-4123-5 * the whole document * | 1-14 | |

-/--

The present search report has been drawn up for all claims

| Place of search | Date of completion of the search | Examiner |
|---|---|---|
| Munich | 16 May 2014 | Streif, Jörg Ulrich |

EPO FORM 1503 03.82 (P04C01)

Europäisches
Patentamt

European
Patent Office

Office européen
des brevets

## EUROPEAN SEARCH REPORT

**Application Number**

EP 13 19 7707

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2011/033402 A1 (KONINKL PHILIPS ELECTRONICS NV [NL]; HARVEY PAUL R [NL]; HOLTHUIZEN RO) 24 March 2011 (2011-03-24) * the whole document * | 1-14 | |
| A | WO 2007/042951 A1 (KONINKL PHILIPS ELECTRONICS NV [NL]; ZHAI ZHIYONG [US]; MORICH MICHAEL) 19 April 2007 (2007-04-19) * the whole document * | 1-14 | |
| A | US 2006/054810 A1 (GRASSLIN INGMAR [DE] ET AL GRAEBETALIN INGMAR [DE] ET AL) 16 March 2006 (2006-03-16) * the whole document * | 1-14 | |
| A | US 2010/237869 A1 (GRISWOLD MARK A [US] ET AL) 23 September 2010 (2010-09-23) * the whole document * | 1-14 | |

**TECHNICAL FIELDS SEARCHED (IPC)**

The present search report has been drawn up for all claims

| Place of search | Date of completion of the search | Examiner |
|---|---|---|
| Munich | 16 May 2014 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 19 7707

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2014

| Patent document cited in search report | | Publication date | Patent family member(s) | | Publication date |
|---|---|---|---|---|---|
| US 2012223706 | A1 | 06-09-2012 | NONE | | |
| US 2008218168 | A1 | 11-09-2008 | NONE | | |
| US 2005134270 | A1 | 23-06-2005 | NONE | | |
| WO 2011033402 | A1 | 24-03-2011 | CN | 102498411 A | 13-06-2012 |
| | | | EP | 2478384 A1 | 25-07-2012 |
| | | | JP | 2013505046 A | 14-02-2013 |
| | | | US | 2012161766 A1 | 28-06-2012 |
| | | | WO | 2011033402 A1 | 24-03-2011 |
| WO 2007042951 | A1 | 19-04-2007 | CN | 101283286 A | 08-10-2008 |
| | | | EP | 1934622 A1 | 25-06-2008 |
| | | | JP | 2009511106 A | 19-03-2009 |
| | | | US | 2008265889 A1 | 30-10-2008 |
| | | | WO | 2007042951 A1 | 19-04-2007 |
| US 2006054810 | A1 | 16-03-2006 | AU | 2003285670 A1 | 29-07-2004 |
| | | | CN | 1735814 A | 15-02-2006 |
| | | | EP | 1585990 A1 | 19-10-2005 |
| | | | JP | 4376791 B2 | 02-12-2009 |
| | | | JP | 2006512949 A | 20-04-2006 |
| | | | US | 2006054810 A1 | 16-03-2006 |
| | | | WO | 2004061469 A1 | 22-07-2004 |
| US 2010237869 | A1 | 23-09-2010 | US | 2010237869 A1 | 23-09-2010 |
| | | | US | 2011279118 A1 | 17-11-2011 |

EPO FORM P0459

For more details about this annex : see Official Journal of the European Patent Office, No. 12/82

**EP 2 887 087 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JESSE BUTLER ; RALPH LOWE.** Beam-Forming Matrix Simplifies Design of Electronically Scanned Antennas. *Electronic Design,* 1961, vol. 9, 170-173